# FASCICULE DE BREVET EUROPEEN

(11) **EP 1 240 693 B1**
(45) Date de publication et mention de la délivrance du brevet: **17.08.2005**
(21) Numéro de dépôt: 00993664.2
(22) Date de dépôt: 22.12.2000
(51) Int. Cl.: H01S 3/067, G02B 6/42

(54) **COMPOSANT HYBRIDE D'OPTOCOUPLAGE**
HYBRIDE OPTISCHE KOPPLUNGSKOMPONENTE
HYBRID OPTICAL COUPLING COMPONENT

(30) Priorité: 23.12.1999 FR 9916414
(43) Date de publication de la demande: 18.09.2002
(73) Titulaire: KEOPSYS, 22300 Lannion (FR)
(72) Inventeur: LE FLOHIC, Marc, F-22700 Saint Quay Perros (FR)
(74) Mandataire: Breese, Pierre
(86) Numéro de dépôt international: PCT/FR2000/003675
(87) Numéro de publication internationale: WO 2001/048878

(56) Documents cités:
- EP-A- 0 100 086
- EP-A- 0 917 263
- DE-A- 4 402 166
- US-A- 5 854 865
- US-A- 5 919 383
- RIPIN D J ET AL: "HIGH EFFICIENCY SIDE-COUPLING OF LIGHT INTO OPTICAL FIBRES USING IMBEDDED V-GROOVES" ELECTRONICS LETTERS,GB,IEE STEVENAGE, vol. 31, no. 25, 7 décembre 1995 (1995-12-07), pages 2204-2205, XP000546817 ISSN: 0013-5194

## Description

La présente invention concerne un composant hybride d'optocouplage.

On connaît dans l'état de la technique des dispositifs de couplage optique pour le pompage de fibres optiques constitués par un support pour recevoir une fibre optique présentant une encoche, et une diode électroluminescente éclairant cette encoche. Un tel dispositif de couplage est décrit dans le brevet américain US5854865 qui concerne le couplage d'une fibre pour le pompage optique.

Un autre brevet européen EP812039 décrit une source de lumière à fibre avec coupleur à fibre multimode

Le but de la présente invention est de proposer un composant présentant des améliorations par rapport aux dispositifs de l'art antérieur, pour des applications d'amplification optique ou de pompage de cavité laser.

À ce titre, l'invention concerne dans son acception la plus générale un composant hybride multiplexeur d'optocouplage conforme à la revendication 1. D'autres modes de réalisation sont définis dans les revendications 2-13.

Avantageusement, la platine métallique est constitué par un support en cuivre apte à recevoir la diode multimode, ledit support en cuivre étant couplé thermiquement à un élément à effet Peltier.

Selon un autre mode de mise en oeuvre avantageux, l'encoche comporte un revêtement réfléchissant afin d'augmenter la réflexion de la lumière de pompe sur l'encoche.

Selon une première variante, la diode est fixée sur le support en cuivre avec une soudure basse température.

Selon une deuxième variante, la diode est fixée sur le support en cuivre par une liaison mécanique sur une feuille d'indium.

Selon un mode de réalisation préféré, le composant comporte en outre une combinaison de deux lentilles croisées à 90° pour limiter la divergence de la diode dans les plans parallèle et perpendiculaire à la jonction semi-conductrice et assurer la collimation du faisceau lumineux produit par la diode multimode sur l'encoche de la fibre optique.

Avantageusement, il comporte en outre une lame de verre ou une lame biréfringente pour le maintien de la fibre double gaine au niveau de l'encoche.

Selon une variante, ladite lame est collée sur un support de faible conductivité.

Avantageusement, ladite lame est recouvert d'un film métallique sur ses bords, afin de permettre la soudure sur le support de fibre.

Selon une application particulière, le composant hybride selon l'invention comporte une fibre double gaine pour le transport du signal et la lumière de pompage, pour la réalisation du pompage optique d'une cavité laser.

Selon une autre application, le composant hybride selon l'invention comporte une fibre optique monomode pour le transport du signal et une fibre double gaine pour le transport du signal et la lumière de pompage, pour la réalisation d'une amplification optique.

L'invention sera mieux comprise à la lecture de la description qui suit, se référant à un exemple de réalisation non limitatif, se référant aux dessins annexés où :

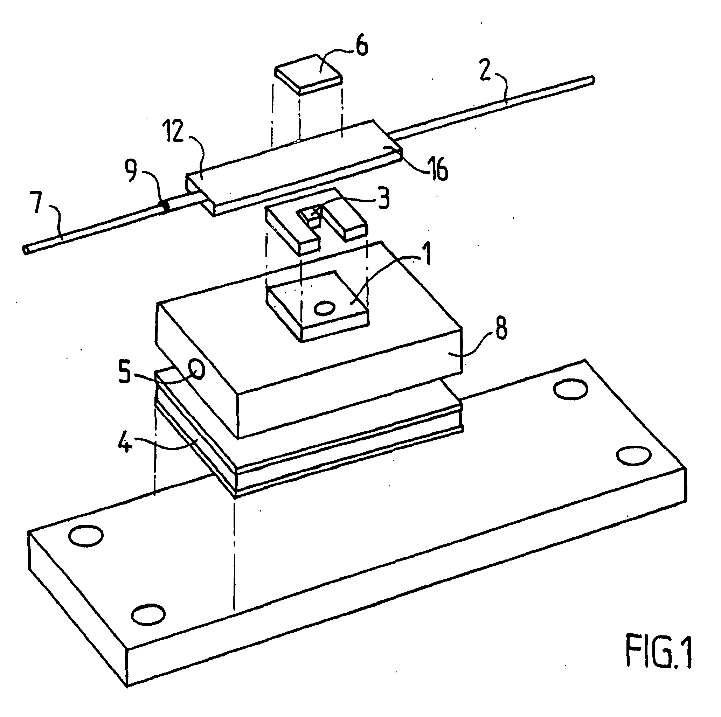

- la figure 1 représente une vue éclatée d'un composant d'optocouplage selon l'invention ,

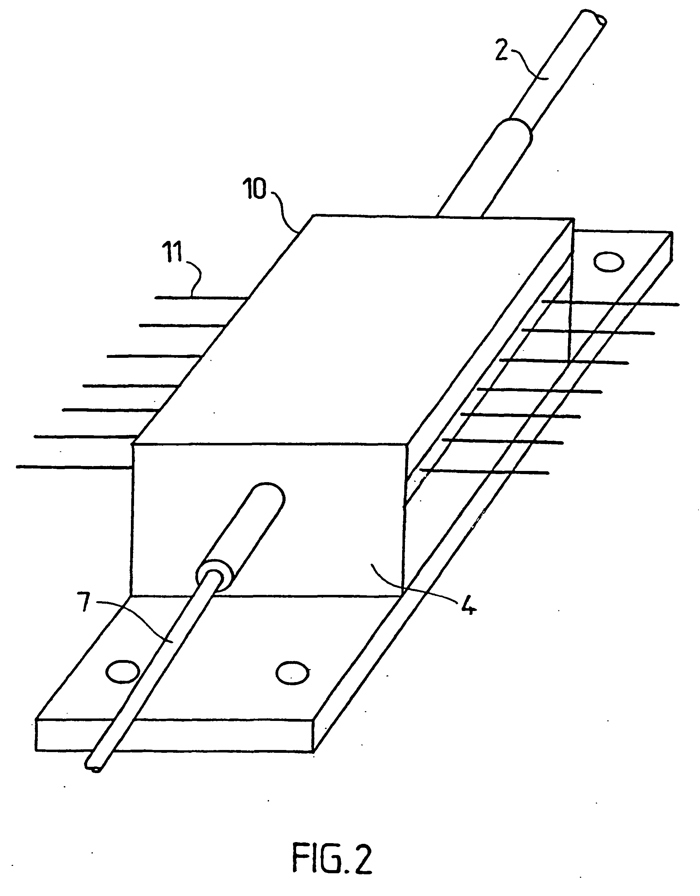

- la figure 2 représente une vue extérieure d'un composant d'optocouplage selon l'invention ,

Le module multiplexeur décrit à titre d'exemple non limitatif comprend :
- une diode semi-conductrice (1) multimode de forte puissance
- une ou plusieurs fibres double gaine (2) avec une ou plusieurs encoches de couplage
- une lentille (3) de couplage
- une lame demi-onde (12)
- un élément Peltier (4)
- un capteur de température (5)
- un photodiode (6).

Ces composants sont intégrés dans un boîtier hermétique (10) comportant un brochage électrique (11) et, :
- pour les applications d'amplification optique : une fibre optique monomode (7) transportant le signal et une fibre double gaine transportant le signal et la pompe ;
- pour les applications de pompage de cavité de laser : une fibre double gaine transportant le signal et la pompe.

La diode laser (1) est montée sur un support (8) en cuivre permettant une évacuation de la chaleur vers l'élément Peltier (4) sur lequel il est fixé. La diode (1) peut être soudée avec une soudure basse température ou vissée sur une feuille d'indium.

La fibre optique (7) est soudée sur le support de cuivre (8) par une lamelle métallique (9).

La lentille (3) est collée sur un support de verre traité anti-reflet à la longueur d'onde de la pompe. La lame de verre peut être remplacée par une lame demi-onde dont la fonction est d'assurer un support mécanique et une orientation de la polarisation de la diode de pompe afin de maximiser le couplage. La colle utilisée est d'indice adéquat pour limiter les réflexions de Fresnel.

La fibre double gaine (2) présente une encoche réalisée par usinage mécanique. Un couteau métallique recouvert d'une pâte diamantée entraînée dans un mouvement de translation perpendiculairement à la fibre. Le contrôle de la profondeur de l'encoche est réalisée par des capteurs de position.

La lame de verre (16) ou la lame biréfringente maintenant la fibre double gaine (2) est collée sur un support en métal de faible conductivité thermique. Elle peut selon une autre réalisation être recouverte d'un film métallique sur les bords pour pouvoir la souder au support de fibre. La géométrie de ce support métallique est conçue afin de créer des ponts thermiques pour permettre le soudage sur le bloc de cuivre de la diode. Le support de lentille présente une ouverture au niveau de l'encoche pour pouvoir la visualiser lors de l'opération de couplage de la diode dans la fibre.

La lentille est une combinaison de deux lentilles croisées à 90° pour pouvoir limiter la divergence de la diode dans les plans parallèle et perpendiculaire à la jonction semi-conductrice. Elle peut également imager la surface émettrice de la diode sur l'encoche. Elle est collée ou soudée sur un support métallique de faible conductivité thermique. La géométrie du support est conçue afin de créer des ponts thermiques afin de permettre le soudage de la diode sur le bloc de cuivre.

En l'absence de lentille, l'alignement de la diode avec la fibre peut être effectué de façon passive, à l'aide d'un microscope binoculaire. Avec une lentille, il est possible d'optimiser le rapport de coupage de la pompe dans la fibre double-gaine, en alignant la lentille et la fibre sur la diode à l'aide d'un détecteur contrôlant la pompe couplée dans la fibre, ou le signal généré par la pompe dans le cas d'une fibre double-gaine dopée aux ions de terres rares ou avec des dopants luminescents. Pour cela, on positionne la lentille par rapport à la diode en visualisant le champ proche et/ou le champ lointain. Ensuite, la fibre est placée contre la lentille et le repérage de l'encoche se fait en observant la lumière de pompe de la fibre. Quand l'encoche réfléchit la lumière de pompe dans la fibre, la lumière de pompe transmise à travers la fibre est fortement atténuée et la fibre double gaine guide partiellement la lumière de pompe. L'optimisation du couplage est effectué par ajustements successifs des positions de la fibre et de la lentille.

Une fois l'optimisation achevée, le support de lentille est soudé avec une soudure basse température sur les cavaliers fixés sur le bloc de cuivre de la diode. Il peut également être collé avec de la colle époxy à faible rétreint.

L'invention est décrite dans ce qui précède à titre d'exemple de mise en oeuvre.

## Revendications

1. Composant hybride multiplexeur d'optocouplage comportant au moins une fibre optique pour le couplage optique transverse avec une diode semi-conductrice **caractérisé en ce que** ladite diode est une diode semi-conductrice multimode (1) et la fibre optique est une fibre à double gaine (2) présentant au moins une encoche et **en ce que** la fibre optique et la diode sont intégrés dans un boîtier hermétique (10) pour former un composant hybride comportant en outre une platine métallique supportant ladite diode de pompage et comprenant:
- pour les applications d'amplification optique, une fibre optique monomode (7) transportant le signal et une fibre double gaine transportant le signal et la pompe;
- et pour les applications de pompage de cavité de laser, une fibre double gaine transportant le signal et la pompe.

2. Composant d'optocouplage comportant au moins une fibre optique à double gaine (2) selon la revendication 1 **caractérisé en ce que** ladite fibre optique à double gaine présente plusieurs encoches.

3. Composant d'optocouplage comportant au moins une fibre optique à double gaine (2) selon la revendication 2 **caractérisé en ce que** le couplage optique transverse avec une diode semi-conductrice forme formant sur l'encoche une tache lumineuse dont la mesure de la section est inférieure à la mesure de la projection de la section sur un plan perpendiculaire à l'axe optique de la diode (1).

4. Composant d'optocouplage comportant au moins une fibre optique à double gaine (2) selon la revendication 1 **caractérisé en ce que** le composant hybride comporte en outre une platine métallique supportant ladite diode de pompage.

5. Composant hybride d'optocouplage selon la revendication 1 **caractérisé en ce que** la platine métallique est constituée par un support en cuivre apte à recevoir la diode multimode (1), ledit support en cuivre étant couplé thermiquement à un élément à effet Peltier (4).

6. Composant hybride d'optocouplage selon la revendication 5 **caractérisé en ce que** la diode est fixée sur le support en cuivre avec une soudure basse température.

7. Composant hybride d'optocouplage selon la revendication 5 **caractérisé en ce que** la diode (1) est fixée sur le support en cuivre (8) par une liaison mécanique sur une feuille d'indium.

8. Composant hybride d'optocouplage selon l'une au moins des revendications précédentes **caractérisé en ce qu'**il comporte en outre une combinaison de deux lentilles (3) croisées à 90° pour limiter la divergence de la diode dans les plans parallèle et perpendiculaire à la jonction semi-conductrice et assurer la collimation du faisceau lumineux produit par la diode multimode sur l'encoche de la fibre optique.

9. Composant hybride d'optocouplage selon l'une au moins des revendications précédentes **caractérisé en ce qu'**il comporte en outre une lame de verre (16) ou une lame biréfringente pour le maintien de la fibre double gaine au niveau de l'encoche.

10. Composant hybride d'optocouplage selon la revendication 9 **caractérisé en ce que** ladite lame est collée sur un support de faible conductivité.

11. Composant hybride d'optocouplage selon la revendication 9 **caractérisé en ce que** ladite lame est recouvert d'un film métallique (9) sur ses bords, afin de permettre la soudure sur le support de fibre.

12. Composant hybride d'optocouplage selon l'une au moins des revendications précédentes **caractérisé en ce qu'**il comporte une fibre double gaine pour le transport du signal et la lumière de pompage, pour la réalisation du pompage optique d'une cavité laser.

13. Composant hybride d'optocouplage selon l'une au moins des revendications précédentes **caractérisé en ce qu'**il comporte une fibre optique monomode pour le transport du signal et une fibre double gaine pour le transport du signal et la lumière de pompage, pour la réalisation d'une amplification optique.

## Patentansprüche

1. Multiplexer-Optokoppler-Hybridbauteil, das mindestens einen Lichtwellenleiter für die transversale optische Koppelung mit einer Halbleiterdiode umfasst, **dadurch gekennzeichnet, dass** die besagte Diode eine Multimodus-Halbleiterdiode (1) ist und der Lichtwellenleiter eine Faser mit doppelter Ummantelung (2) ist, der mindestens eine Kerbe aufweist und dass der Lichtwellenleiter und die Diode in einem luftdichten Gehäuse (10) untergebracht sind, um ein Hybridbauteil zu bilden, das außerdem eine Metallplatine umfasst, die die besagte Pumpdiode trägt und - für Anwendungen der optischen Verstärkung einen Monomodus-Lichtwellenleiter (7), der das Signal transportiert und eine Faser mit doppelter Ummantelung, die das Signal und die Pumpe transportiert; - und für die Pumpanwendungen der Laserkavität eine Faser mit doppelter Ummantelung, die das Signal und die Pumpe transportiert.

2. Optokoppler-Bauteil, das mindestens einen Lichtwellenleiter mit doppelter Ummantelung (2) umfasst, gemäß dem Anspruch 1, **dadurch gekennzeichnet, dass** der besagte Lichtwellenleiter mit doppelter Ummantelung mehrere Kerben aufweist.

3. Optokoppler-Bauteil, das mindestens einen Lichtwellenleiter mit doppelter Ummantelung (2) umfasst, gemäß dem Anspruch 2, **dadurch gekennzeichnet, dass** die transversale optische Koppelung mit einer Halbleiterdiode, die auf der Kerbe einen Lichtfleck bildet, dessen Abmessung des Querschnitts kleiner ist als die Abmessung der Abbildung des Querschnitts in einer Ebene senkrecht zur optischen Achse der Diode (1).

4. Optokoppler-Bauteil, das mindestens einen Lichtwellenleiter mit doppelter Ummantelung (2) umfasst, gemäß dem Anspruch 1, **dadurch gekennzeichnet, dass** das Hybridbauteil außerdem eine Metallplatine umfasst, die die besagte Pumpdiode trägt.

5. Hybrid-Optokoppler-Bauteil, gemäß dem Anspruch 1, **dadurch gekennzeichnet, dass** die Metallplatine aus einem Kupferträger besteht, der die Multimodus-Diiode (1) aufnehmen kann, wobei der besagte Kupferträger thermisch an ein Element mit Peltier-Effekt (4) gekoppelt ist.

6. Hybrid-Optokoppler-Bauteil, gemäß dem Anspruch 5, **dadurch gekennzeichnet, dass** die Diode auf dem Kupferträger mittels einer bei niedriger Temperatur hergestellten Schweißnaht befestigt ist.

7. Hybrid-Optokoppler-Bauteil, gemäß dem Anspruch 5, **dadurch gekennzeichnet, dass** die Diode (1) auf dem Kupferträger (8) durch eine mechanische Verbindung auf einer Indiumfolie befestigt ist.

8. Hybrid-Optokoppler-Bauteil, gemäß mindestens einem der vorherigen Ansprüche, **dadurch gekennzeichnet, dass** es außerdem eine Kombination von zwei Linsen (3) umfasst, die bei 90° gekreuzt sind, um die Abweichung der Diode in den Ebenen parallel und senkrecht zur Halbleiterverbindung zu begrenzen und die Kollimation des Lichtbündels zu garantieren, das durch die Multimodus-Diode und die Kerbe des Lichtwellenleiters entsteht.

9. Hybrid-Optokoppler-Bauteil, gemäß mindestens einem der vorherigen Ansprüche, **dadurch gekennzeichnet, dass** es außerdem eine Glasscheibe (16) umfasst oder eine Scheibe mit Doppelbrechung, um die Faser mit doppelter Ummantelung im Bereich der Kerbe zu halten.

10. Hybrid-Optokoppler-Bauteil, gemäß dem Anspruch 9, **dadurch gekennzeichnet, dass** die besagte Scheibe auf einen Träger mit geringer Leitfähigkeit geklebt ist.

11. Hybrid-Optokoppler-Bauteil, gemäß dem Anspruch 9, **dadurch gekennzeichnet, dass** die besagte Scheibe an ihren Rändern mit einem Metallfilm (9) überzogen ist, um eine Schweißnaht auf dem Faserträger zu ermöglichen.

12. Hybrid-Optokoppler-Bauteil, gemäß mindestens einem der vorherigen Ansprüche, **dadurch gekennzeichnet, dass** es eine Faser mit doppelter Ummantelung für den Transport des Signals und das Pumplicht zur Durchführung des optischen Pumpens einer Laserkavität umfasst.

13. Hybrid-Optokoppler-Bauteil, gemäß mindestens einem der vorherigen Ansprüche, **dadurch gekennzeichnet, dass** es einen Monomodus-Lichtwellenleiter für den Transport des Signals umfasst und eine Faser mit doppelter Ummantelung für den Transport des Signals und das Pumplicht zur Durchführung einer optischen Verstärkung.

## Claims

1. Opto-coupling multiplexer hybrid component comprising at least an optical fibre for transversal optical coupling with a semiconductor diode **characterised in that** said diode is a multimode semiconductor diode (1) and the optical fibre is a dual-cladded fibre (2) having at least a slot and **in that** the optical fibre and the diode are integrated into an airtight box (10) to create a hybrid component further comprising a metal plate supporting said pumping diode and comprising:
- for optical amplification applications, a single-mode optical fibre (7) carrying the signal and a dual-cladded fibre carrying the signal and the pump; and
- for laser cavity pumping applications, a dual-cladded fibre carrying the signal and the pump.

2. Opto-coupling component comprising at least a dual-cladded optical fibre (2) set forth in claim 1 **characterised in that** said dual-cladded optical fibre has several slots.

3. Opto-coupling component comprising at least a dual-cladded optical fibre (2) set forth in claim 2 **characterised in that** the transversal optical coupling with a semiconductor diode creates a splash of light on the slot whose cross section dimension is less than the dimension of the projection of the cross section onto a plane perpendicular to the optical axis of the diode (1).

4. Opto-coupling component comprising at least a dual-cladded optical fibre (2) set forth in claim 1 **characterised in that** the hybrid component further comprises a metal plate supporting said pumping diode.

5. Hybrid opto-coupling component set forth in claim 1 **characterised in that** the metal plate is composed of a copper support ready to hold the multimode diode (1), said copper support being heat coupled to a Peltier effect element (4).

6. Hybrid opto-coupling component set forth in claim 5 **characterised in that** the diode is attached to the copper support using a low-temperature weld.

7. Hybrid opto-coupling component set forth in claim 5 **characterised in that** the diode (1) is attached to the copper support (8) via a mechanical bond on a sheet of indium.

8. Hybrid opto-coupling component set forth in at least one of the previous claims **characterised in that** it further comprises a combination of two lenses (3) intersecting at 90° so as to limit the deviation of the diode in the planes parallel and perpendicular to the semiconductor joint and to ensure the collimation of the light beam produced by the multimode diode over the slot of the optical fibre.

9. Hybrid opto-coupling component set forth in at least one of the previous claims **characterised in that** it further comprises a strip of glass (16) or a birefringent strip so that the dual-cladded fibre remains at the same level as the slot.

10. Hybrid opto-coupling component set forth in claim 9 **characterised in that** said strip is bonded onto a low conductive support.

11. Hybrid opto-coupling component set forth in claim 9 **characterised in that** the edges of said strip are coated in a metal film (9) so that it can be welded onto the support of the fibre.

12. Hybrid opto-coupling component set forth in at least one of the previous claims **characterised in that** it comprises a dual-cladded fibre to carry the signal and the pumping light for the optical pumping of a laser cavity.

13. Hybrid opto-coupling component set forth in at least one of the previous claims **characterised in that** it comprises a single mode optical fibre to carry the signal and a dual-cladded fibre to carry the signal and the pumping light for optical amplification.
